(19) Europäisches Patentamt
European Patent Office
Office européen des brevets

(11) **EP 4 331 766 A1**

(12) **EUROPEAN PATENT APPLICATION**
published in accordance with Art. 153(4) EPC

(43) Date of publication:
**06.03.2024 Bulletin 2024/10**

(21) Application number: **22795790.9**

(22) Date of filing: **26.04.2022**

(51) International Patent Classification (IPC):
**B23K 20/00** (2006.01)          **H01L 23/36** (2006.01)
**H05K 7/20** (2006.01)

(52) Cooperative Patent Classification (CPC):
**B23K 20/00; H01L 23/36; H05K 7/20**

(86) International application number:
**PCT/JP2022/018886**

(87) International publication number:
**WO 2022/230877 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **27.04.2021   JP 2021074746**

(71) Applicant: **Mitsubishi Materials Corporation
Tokyo 100-8117 (JP)**

(72) Inventors:
• **OHASHI, Toyo**
  **Saitama-shi, Saitama 330-8508 (JP)**
• **KUROMITSU, Yoshiro**
  **Naka-shi, Ibaraki 311-0102 (JP)**
• **IWAZAKI, Wataru**
  **Saitama-shi, Saitama 330-8508 (JP)**

(74) Representative: **Hoffmann Eitle
Patent- und Rechtsanwälte PartmbB
Arabellastraße 30
81925 München (DE)**

(54) **HEAT SINK, AND HEAT SINK INTEGRATED-TYPE INSULATING CIRCUIT BOARD**

(57)    A heat sink includes a top plate part and a radiating fin. One surface of the top plate part serves as a placement surface on which another member is placed, and a radiating fin is formed on the other surface of the top plate part. The top plate part has a clad structure in which an aluminum layer formed of aluminum or an aluminum alloy and a copper layer formed of copper or a copper alloy are subjected to solid-phase diffusion bonding. The average crystal grain size of the aluminum layer is set to be within a range of 50 $\mu$m or more and less than 500 $\mu$m, and a thickness of an Al-Cu intermetallic compound layer formed between the aluminum layer and the copper layer is set to be within a range of more than 10 $\mu$m and 40 $\mu$m or less.

FIG. 2

**Description**

[Technical Field]

The present invention relates to a heat sink including a top plate part and a radiating fin, and a heat sink integrated insulating circuit substrate including the heat sink.
Priority is claimed on Japanese Patent Application No. 2021-074746, filed on April 27, 2021, the content of which is incorporated herein by reference.

[Background Art]

A power module, an LED module, and a thermoelectric module have a structure in which a power semiconductor element, an LED element, and a thermoelectric element are bonded to an insulating circuit substrate in which a circuit layer made of a conductive material formed on one surface of an insulating layer. As the insulating layer, one using ceramics or one using an insulating resin has been proposed.
Further, in such an insulating circuit substrate, a heat sink is arranged to radiate heat from mounted elements.
For example, Patent Document 1 proposes a heat sink integrated insulating circuit substrate in which a heat sink and a circuit layer are insulated by an insulating resin sheet.
In addition, Patent Document 2 proposes an insulating circuit substrate with a heat sink, in which a heat sink and an insulating circuit substrate in which metal plates are bonded to both surfaces of a ceramic substrate are bonded.
As the above-described heat sink, a heat sink having a structure including a top plate part and radiating fins is provided. One surface of the top plate part serves as a mounting surface of the insulating circuit substrate, and the radiating fins are arranged on the other surface side of the top plate part.
As the radiating fins, radiating fins having various shapes, such as pin fins, comb-shaped fins, and corrugated fins, have been proposed.
Here, examples of a material forming the above-described heat sink include copper, a copper alloy, aluminum, or an aluminum alloy having excellent thermal conductivity.
A copper member formed of copper or a copper alloy has characteristics of particularly excellent in thermal conductivity, high mechanical strength, and high deformation resistance.
On the other hand, an aluminum member formed of aluminum or an aluminum alloy has characteristics in that the aluminum member is slightly inferior in thermal conductivity to copper, but has a light weight, low deformation resistance, and easy molding of a complicated shape.
Therefore, in the above-described heat sink, a copper or a copper alloy, and an aluminum or an aluminum alloy are selected and used in accordance with the required performance. In the recent years, a heat sink having a structure in which a copper member and an aluminum member are bonded to each other is required.
Here, as a method for bonding the copper member and the aluminum member, for example, a solid-phase diffusion bonding method as disclosed in Patent Documents 3 and 4 has been proposed.

[Citation List]

[Patent Documents]

[Patent Document 1]
Japanese Unexamined Patent Application, First Publication No. H11-204700
[Patent Document 2]
Japanese Unexamined Patent Application, First Publication No. 2004-022914
[Patent Document 3]
Japanese Unexamined Patent Application, First Publication No. 2014-076486
[Patent Document 4]
Republished Japanese Translation No. WO2011/155379 of the PCT International Publication for Patent Applications

[Summary of Invention]

[Technical Problem]

Here, in Patent Document 3, a copper member and an aluminum member are subjected to solid-phase diffusion bonding, and the average crystal grain size of the aluminum member after bonding is set to 500 μm or more. When the average crystal grain size is coarse as described above, the deformation resistance of the aluminum member is low, and there is a concern that the aluminum member is easily deformed during use.

Further, in Patent Document 4, the average thickness of an Al-Cu intermetallic compound layer formed between a copper layer and an aluminum layer is as thin as 0.5 μm to 10 μm. As described above, when the Al-Cu intermetallic compound layer is thin, solid-phase diffusion of copper and aluminum is not sufficiently performed, and there is a concern that the bonding reliability deteriorates.

The present invention has been made in view of the above-described circumstances, an object of the present invention is to provide a heat sink and a heat sink integrated insulating circuit substrate including the heat sink in which a copper layer formed of copper or a copper alloy and an aluminum layer formed of aluminum or an aluminum alloy are provided, bonding reliability between the copper layer and the aluminum layer is excellent, it is possible to suppress deformation of a member formed of aluminum or an aluminum alloy, and stable use is possible.

[Solution to Problem]

In order to solve the above problems and achieve the object, according to the present invention, a heat sink includes a top plate part and a radiating fin. One surface of the top plate part serves as a placement surface on which another member is placed, and a radiating fin is formed on the other surface of the top plate part. The top plate part has a clad structure in which an aluminum layer formed of aluminum or an aluminum alloy and a copper layer formed of copper or a copper alloy are subjected to solid-phase diffusion bonding. The average crystal grain size of the aluminum layer is set to be within a range of 50 μm or more and less than 500 μm, and the thickness of an Al-Cu intermetallic compound layer formed between the aluminum layer and the copper layer is set to be within a range of more than 10 μm and 40 μm or less.

According to the heat sink having this configuration, the top plate part has a clad structure in which the aluminum layer formed of aluminum or an aluminum alloy and a copper layer formed of copper or a copper alloy are subjected to solid-phase diffusion bonding. Thus, it is possible to spread heat from another member placed on a placement surface, along a plate surface of the top plate part by the copper layer with high efficiency, and radiating characteristics are excellent. Further, since the heat sink includes the aluminum layer, it is possible to reduce the weight of the heat sink.

Further, since the aluminum layer and the copper layer are subjected to solid-phase diffusion bonding and the average crystal grain size of the aluminum layer is set to be 50 μm or more and less than 500 μm, the aluminum layer is appropriately hardened, and it is possible to suppress deformation of the aluminum layer.

In addition, since the thickness of the Al-Cu intermetallic compound layer formed between the aluminum layer and the copper layer is set to be within a range of more than 10 μm and 40 μm or less, copper and aluminum are sufficiently subjected to solid-phase diffusion, and the bonding reliability between the copper layer and the aluminum layer is excellent.

Here, in the heat sink according to the present invention, the aluminum layer and the radiating fin may be integrally molded.

In this case, since the aluminum layer and the radiating fin are integrally molded with aluminum or an aluminum alloy, which are relatively easy to mold, it is possible to form a radiating fin having a complicated shape, and it is possible to further improve the radiating characteristics.

Further, since the radiating fin is integrally molded with the aluminum layer, it is possible to suppress falling-off or deformation of the radiating fin.

Further, in the heat sink according to the present invention, it is preferable that purity of aluminum in the aluminum layer is 99.5 mass% or less.

In this case, since the purity of aluminum in the aluminum layer is 99.5 mass% or less and a certain amount of impurities are contained, it is possible to suppress the growth of crystal grains by the impurities, and to reliably suppress the coarsening of the crystal grains in the aluminum layer after bonding.

According to the present invention, a heat sink integrated insulating circuit substrate includes the heat sink described above, an insulating layer formed on the placement surface of the top plate part of the heat sink, and a circuit layer formed on a surface of the insulating layer on an opposite side of the top plate part.

According to the heat sink integrated insulating circuit substrate having this configuration, since the heat sink described above is provided, it is possible to efficiently radiate heat on the insulating circuit substrate side. In addition, it is possible to suppress deformation of the heat sink, and thus the stable use is possible.

[Advantageous Effects of Invention]

According to the present invention, it is possible to provide a heat sink and a heat sink integrated insulating circuit substrate including the heat sink in which a copper layer formed of copper or a copper alloy and an aluminum layer formed of aluminum or an aluminum alloy are provided, bonding reliability between the copper layer and the aluminum layer is excellent, it is possible to suppress deformation of a member formed of aluminum or an aluminum alloy, and stable use is possible.

[Brief Description of Drawings]

FIG. 1 is a schematic diagram of a power module including a heat sink and a heat sink integrated insulating circuit substrate according to an embodiment of the present invention.
FIG. 2 is a diagram of the heat sink in the embodiment of the present invention.
FIG. 3 is an enlarged diagram of a top plate part of the heat sink in the embodiment of the present invention.
FIG. 4 is an observation picture of a bonding interface between a copper layer and an aluminum layer of the top plate part represented in FIG. 3.
FIG. 5 is a flowchart showing a method of manufacturing the heat sink in the embodiment of the present invention.
FIG. 6 is a diagram showing the method of manufacturing the heat sink in the embodiment of the present invention; FIG. 6(a) shows a laminating step, FIG. 6(b) shows a bonding step, and FIG. 6(c) shows a heat sink obtained through the bonding step.
FIG. 7 is a flowchart showing a method of manufacturing a heat sink integrated insulating circuit substrate according to the embodiment of the present invention.
FIG. 8 is a diagram showing the method of manufacturing the heat sink integrated insulating circuit substrate in the embodiment of the present invention; FIG. 8(a) shows a resin composition arrangement step, FIG. 8(b) shows a metal piece disposition step, FIG. 8(c) shows a pressurizing and heating step, and FIG. 8(d) shows a heat sink integrated insulating circuit substrate obtained through the pressurizing and heating step.

[Description of Embodiments]

Hereinafter, an embodiment of the present invention will be described with reference to the drawings. Incidentally, each of the embodiments illustrated below will be specifically described to help better understanding the concept of the invention, and unless otherwise specified, does not limit the invention. In addition, in the drawings used in the following description, in order to facilitate understanding features of the invention, for convenience, portions that are main components may be illustrated in an enlarged manner, and the dimensional ratio or the like of each component may not be the same as the actual one.

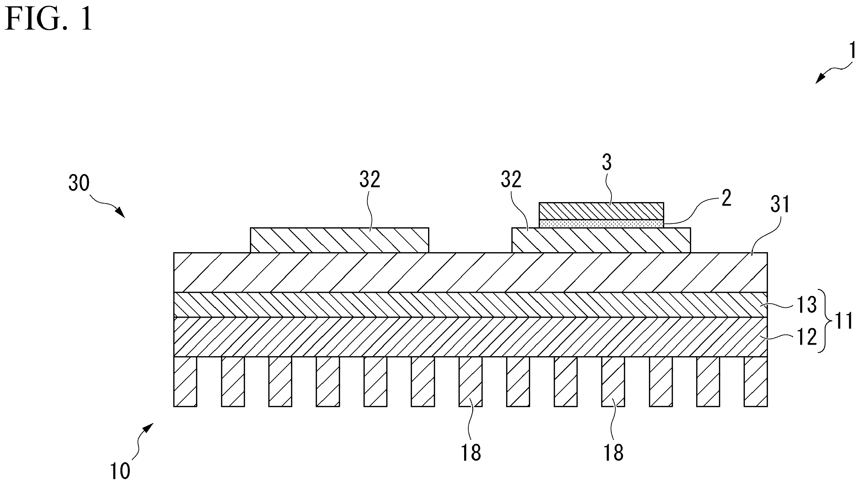

FIG. 1 shows a heat sink 10, a heat sink integrated insulating circuit substrate 30, and a power module 1 using the heat sink integrated insulating circuit substrate 30, according to an embodiment of the present invention.

In FIGS. 1 to 3, 6 and 8, the upper surface of each member is referred to as one surface or a first surface below, and the lower surface of each member is referred to as the other surface or a second surface below.

The power module 1 represented in FIG. 1 includes the heat sink integrated insulating circuit substrate 30 and a semiconductor element 3 bonded to one surface (upper surface in FIG. 1) of the heat sink integrated insulating circuit substrate 30 via a solder layer 2.

The heat sink integrated insulating circuit substrate 30 includes a heat sink 10 in the present embodiment, an insulating layer 31 formed on one surface (upper surface in FIG. 1) of a top plate part 11 of the heat sink 10, and a circuit layer 32 formed on one surface (upper surface in FIG. 1) of the insulating layer 31. The above-described semiconductor element 3 is bonded to one surface (upper surface in FIG. 1) of the circuit layer 32.

The insulating layer 31 prevents an electrical connection between the circuit layer 32 and the heat sink 10, and is formed of an insulating resin in the present embodiment.

In the present embodiment, in order to secure the strength of the insulating layer 31 and to secure the thermal conductivity, it is preferable to use a resin containing a filler of an inorganic material, as the resin forming the insulating layer 31. Here, as the filler, for example, alumina, boron nitride, aluminum nitride, or the like can be used. From the viewpoint of securing the thermal conductivity in the insulating layer 31, the amount of the filler is preferably 50 mass% or more, and more preferably 70 mass% or more.

Further, as a thermosetting resin, an epoxy resin, a polyimide resin, a silicon resin, or the like can be used. Here, when the thermosetting resin is a silicon resin, the thermosetting resin can contain 70 mass% or more of the above-described filler, and, when the thermosetting resin is an epoxy resin, the thermosetting resin can contain 80 mass% or more of the above-described filler.

In order to sufficiently secure the insulating property of the insulating layer 31, the lower limit of the thickness of the insulating layer 31 is preferably set to 25 $\mu$m or more, and more preferably 50 $\mu$m or more. On the other hand, in order to further secure the heat radiation in the heat sink integrated insulating circuit substrate 30, the upper limit of the thickness of the insulating layer 31 is preferably set to 300 μm or less, and more preferably 200 μm or less.

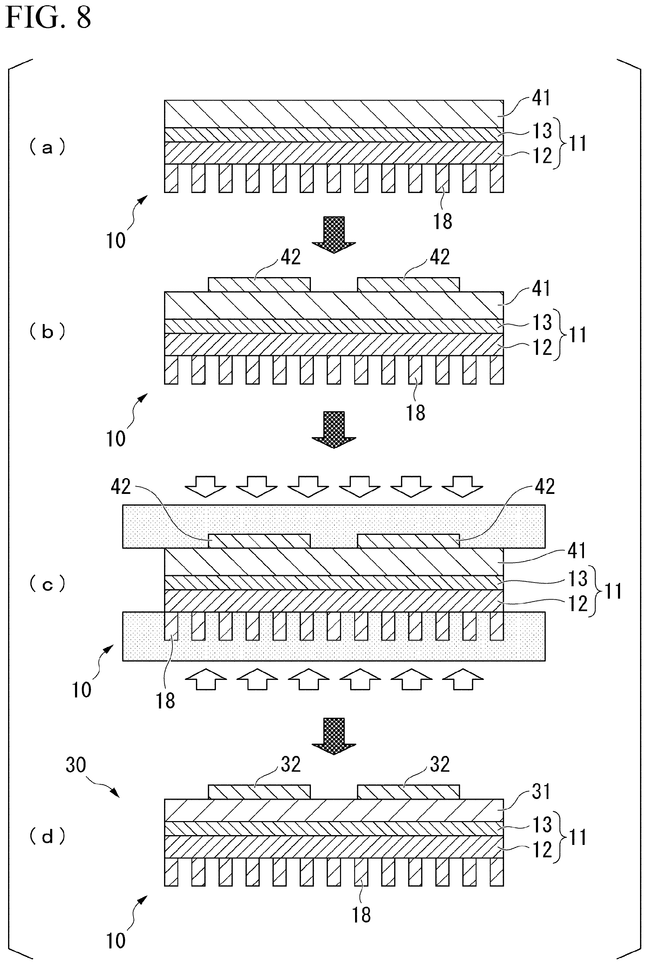

As represented in FIGS. 8(a) to 8(d), the circuit layer 32 is formed by bonding a metal piece 42 that is formed of metal and has excellent electrical conductivity to one surface of the insulating layer 31. As the metal piece 42, copper or a copper alloy, aluminum, an aluminum alloy, or the like can be used. In the present embodiment, as the metal piece 42 constituting the circuit layer 32, a metal piece obtained by punching out a rolled plate of oxygen-free copper is used.

In the circuit layer 32, a circuit pattern is formed, and one surface (upper surface in FIG. 1) of the circuit pattern is set as a mounting surface on which the semiconductor element 3 is mounted.

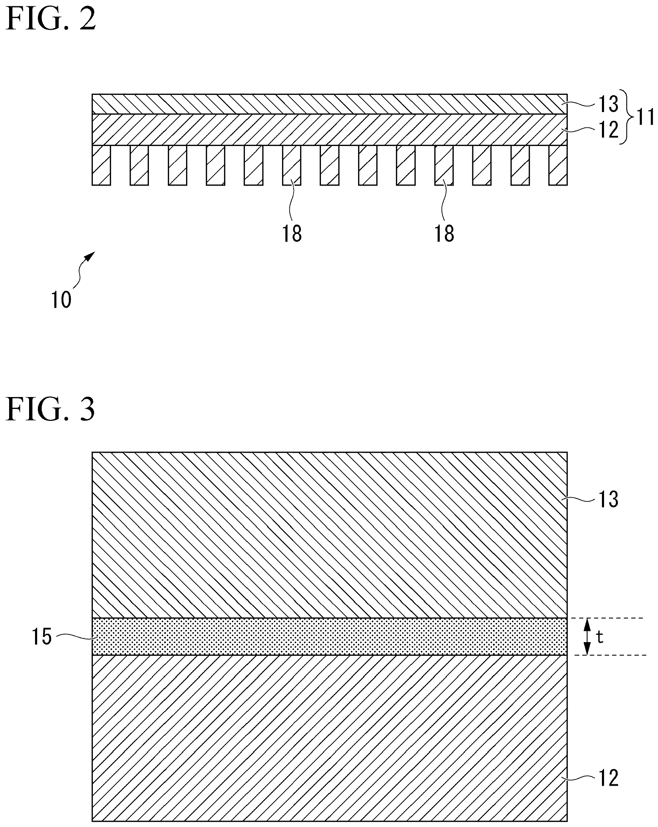

The heat sink 10 in the present embodiment includes the top plate part 11 and radiating fins 18 which protrude from the other surface (lower surface in FIGS. 1 and 2) of the top plate part 11.

The radiating fins 18 may be pin fins, may have a structure formed in a comb shape, or may be corrugated fins. In the present embodiment, a pin fin is used as the radiating fin.

The top plate part 11 has a clad structure in which the aluminum layer 12 formed of aluminum or an aluminum alloy and the copper layer 13 formed of copper or a copper alloy are subjected to solid-phase diffusion bonding.

In the present embodiment, a structure in which the aluminum layer 12 and the radiating fins 18 are integrally molded, and the copper layer 13 is laminated on the aluminum layer 12 is made.

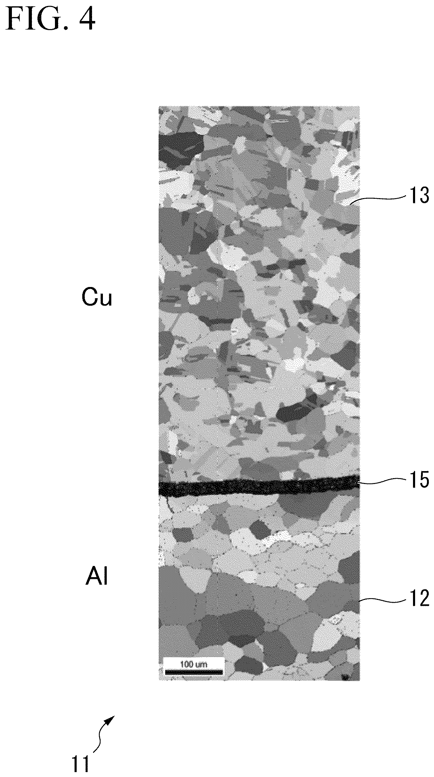

At the bonding interface between the aluminum layer 12 and the copper layer 13, as represented in FIGS. 3 and 4, an Al-Cu intermetallic compound layer 15 is formed by mutual diffusion of Al in the aluminum layer 12 and Cu in the copper layer 13. In FIG. 4, the black part indicates the Al-Cu intermetallic compound layer 15.

An intermetallic compound having a plurality of phases with different composition ratios is used as the intermetallic compound of Al and Cu, but in the present embodiment, the Al-Cu intermetallic compound layer 15 has a structure in which the various phases are laminated.

In the present embodiment, the thickness t of the Al-Cu intermetallic compound layer 15 is set to be within a range of more than 10 μm and 40 μm or less.

Here, when the thickness t of the Al-Cu intermetallic compound layer 15 is set to 10 μm or less, the mutual diffusion between Al and Cu is insufficient, and there is a concern that the bonding strength between the aluminum layer 12 and the copper layer 13 decreases. On the other hand, when the thickness t of the Al-Cu intermetallic compound layer 15 is more than 40 μm, the bonding interface becomes harder than necessary, and thus, when a thermal cycle is applied to the Al-Cu intermetallic compound layer 15, cracks occur in the vicinity of the bonding interface, and there is a concern that the bonding reliability is degraded.

Therefore, in the present embodiment, the thickness t of the Al-Cu intermetallic compound layer 15 is set to be within a range of more than 10 μm and 40 μm or less.

In order to further improve the bonding strength between the aluminum layer 12 and the copper layer 13, the thickness t of the Al-Cu intermetallic compound layer 15 is preferably set to 15 μm or more, and more preferably set to 20 μm or more.

In addition, in order to further improve bonding reliability when the thermal cycle is applied, the thickness t of the Al-Cu intermetallic compound layer 15 is preferably 35 μm or less, and more preferably 30 μm or less.

Further, in the present embodiment, the average crystal grain size D1 of the aluminum layer 12 is set to be within a range of 50 μm or more and less than 500 μm.

Here, when the average crystal grain size D1 of the aluminum layer 12 is less than 50 μm, the aluminum layer 12 is hardened, and thus there is a concern that it is not possible to relieve the thermal stress when the thermal cycle is applied, cracks occur in the vicinity of the bonding interface, and the bonding reliability is degraded. On the other hand, when the average crystal grain size D1 of the aluminum layer 12 is more than 500 μm, the aluminum layer 12 is softened and has low deformation resistance, so that there is a concern that the aluminum layer 12 is easily deformed.

Therefore, in the present embodiment, the average crystal grain size D1 of the aluminum layer 12 is set to be within a range of 50 μm or more and less than 500 μm.

In order to further improve the bonding reliability when the thermal cycle is applied, the average crystal grain size D1 of the aluminum layer 12 is preferably set to 100 μm or more and more preferably set to 150 μm or more.

Furthermore, in order to further suppress the deformation of the aluminum layer 12, the average crystal grain size D1 of the aluminum layer 12 is preferably set to 300 μm or less and more preferably set to 200 μm or less.

Here, the aluminum layer 12 is preferably formed of aluminum and an aluminum alloy having purity of 99.5 mass% or less of aluminum. For example, the aluminum layer 12 can be formed of A1050, A6063, ADC12, or the like. In the present embodiment, since the aluminum layer 12 and the radiating fin 18 are integrally molded, the aluminum layer 12 and the radiating fin 18 are formed of the same material.

The purity of aluminum is more preferably 99.0 mass% or less and 95.0 mass% or more.

When the purity of aluminum in the aluminum layer 12 is 99.5 mass% or less, a certain amount of impurities are contained in the aluminum layer 12. Thus, it is possible to suppress the growth of crystal grains by the impurities, and to reliably suppress the coarsening of the crystal grains in the aluminum layer after bonding.

The purity of aluminum in the aluminum layer 12 can be confirmed by an inductively coupled plasma (ICP) analysis method.

Furthermore, in the present embodiment, the average crystal grain size of the copper layer 13 is not particularly limited, but is preferably in a range of, for example, 50 $\mu$m or more and 300 $\mu$m or less.

The copper or the copper alloy forming the copper layer 13 is also not particularly limited, and for example, oxygen-free copper, tough pitch copper, or the like can be used.

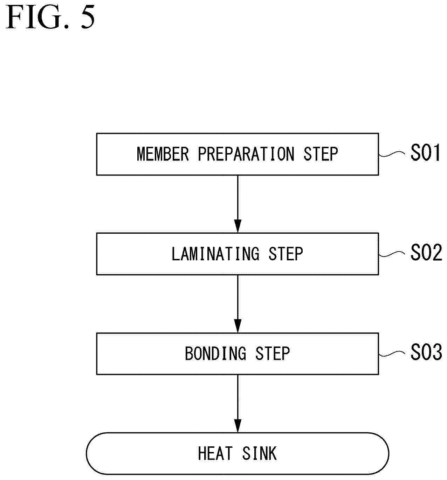

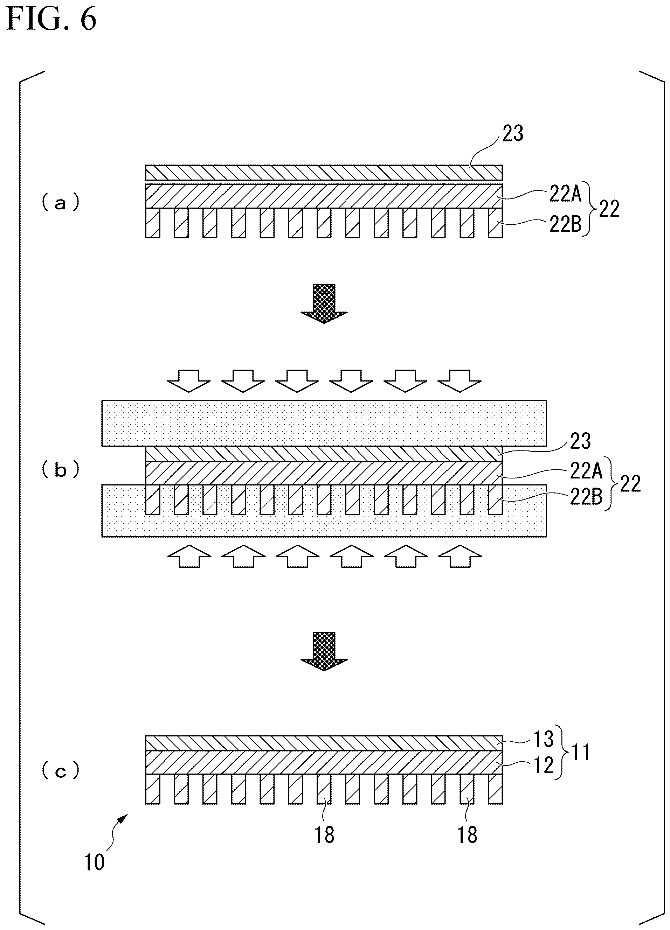

Next, a method of manufacturing the heat sink 10 according to the present embodiment will be described with reference to FIGS. 5 and FIGS. 6(a) to 6(c).

(Member Preparation Step S01)

First, an aluminum member 22 to be the aluminum layer 12 and a copper member 23 to be the copper layer 13 are prepared.

It is preferable that the bonding surface between the aluminum member 22 and the copper member 23 is smooth surfaces by removing scratches or the like in advance by polishing or the like.

Here, the aluminum member 22 has a structure in which an aluminum plate 22A to be the aluminum layer 12, and a fin body 22B to be the radiating fin 18 are integrally molded.

The aluminum member 22 is preferably formed of aluminum or an aluminum alloy in the purity of aluminum is 99.5 mass% or less.

In addition, the average crystal grain size of the aluminum member 22 before bonding is preferably set to be within a range of 5 $\mu$m or more and 30 $\mu$m or less.

(Laminating Step S02)

Then, the copper member 23 is laminated on the aluminum plate 22A of the aluminum member 22 (FIG. 6(a)).

(Bonding Step S03)

Then, the aluminum member 22 and the copper member 23 which have been laminated are introduced into a vacuum furnace. In a vacuum atmosphere, the aluminum member 22 and the copper member 23 are subjected to solid-phase diffusion bonding by pressurizing and heating the aluminum member 22 and the copper member 23 in the laminating direction (FIG. 6(b)).

At this time, it is preferable that a pressurizing load in the laminating direction is set to be within a range of 0.3 MPa or more and 3.5 MPa or less, a bonding temperature is set to be within a range of 400°C or higher and 545°C or lower, a holding time at the bonding temperature is set to be within a range of 5 min or longer and 240 min or shorter, and the degree of vacuum is set to be 0.1 Pa or less.

The pressurizing load is more preferably set to 0.5 MPa or more and further preferably set to 0.8 MPa or more. In addition, the pressurizing load is more preferably set to 2.0 MPa or less and further preferably set to 1.5 MPa or less.

The bonding temperature is more preferably set to 450°C or higher and further preferably set to 480°C or higher. In addition, the bonding temperature is more preferably set to 540°C or lower and further preferably set to 535°C or lower.

The holding time at the bonding temperature is more preferably set to 10 minutes or longer, and further preferably set to 15 minutes or longer. In addition, the holding time at the bonding temperature is more preferably set to 180 minutes or shorter, and further preferably set to 120 minutes or shorter.

The degree of vacuum is more preferably set to 0.05 Pa or less and further preferably set to 0.01 Pa or less.

Here, in the present embodiment, when the average crystal grain size of the aluminum member 22 (aluminum plate 22A) before bonding is set as D0, and the average crystal grain size of the aluminum layer 12 after bonding is set as D1, the amount of change of the crystal grain size represented by the following expression is set to 90% or less.

$$\text{Amount of Change } (\%) = (D1\text{-}D0)/D1 \times 100$$

In the present embodiment, the pressurizing load, the bonding temperature, and the holding time in the bonding step S03 are adjusted within the above ranges so that the above-described amount of change is set to 90% or less.

In the bonding step S03, diffusion and grain growth occur simultaneously. Thus, by limiting the above-described amount of change to 90% or less, the diffusion path can be stabilized and diffusion can proceed uniformly. In addition, the above-described Al-Cu intermetallic compound layer 15 can be made uniform in thickness.

The above-described amount of change is more preferably set to 80% or less and further preferably set to 70% or less. The lower limit of the amount of change is preferably 30%.

With the above steps, the aluminum member 22 and the copper member 23 are subjected to solid-phase diffusion bonding, and the heat sink 10 in the present embodiment can be manufactured (FIG. 6(c)).

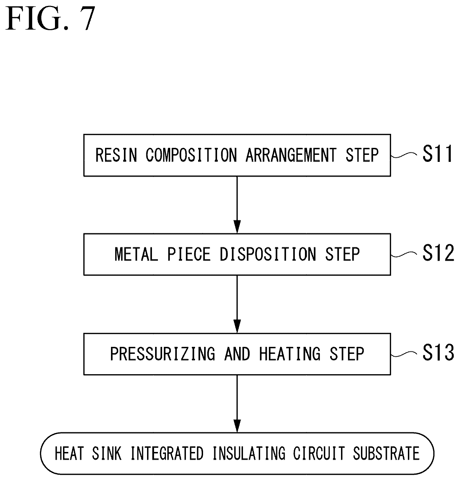

Next, a method of manufacturing the heat sink integrated insulating circuit substrate 30 according to the present embodiment will be described with reference to FIGS. 7 to 8(d).

(Resin Composition Arrangement Step S11)

As represented in FIG. 8(a), a resin composition 41 containing a filler of an inorganic material, a resin, and a curing agent is arranged on one surface (upper surface in FIG. 8(a)) of the top plate part 11 (copper layer 13) of the heat sink 10. In the present embodiment, the resin composition 41 is in the form of a sheet.

(Metal Piece Disposition Step S12)

Then, a plurality of metal pieces 42 serving as the circuit layer 32 are disposed in a circuit pattern on one surface (upper surface in FIG. 5) of the resin composition 41 (FIG. 8(b)).

(Pressurizing and Heating Step S13)

Then, the heat sink 10, the resin composition 41, and the metal piece 42 are pressurized and heated in the laminating direction by a pressurizing device to cure the resin composition 41 and form the insulating layer 31. In addition, the top plate part 11 of the heat sink 10 is bonded to the insulating layer 31, and the insulating layer 31 is bonded to the metal piece 42 (FIG. 8(c)).

In the pressurizing and heating step S13, it is preferable that a heating temperature is set to be within a range of 120°C or higher and 350°C or lower, and the holding time at the heating temperature is set to be within a range of 10 minutes or longer and 180 minutes or lower. Further, it is preferable that the pressurizing load in the laminating direction is set to be within a range of 1 MPa or more and 30 MPa or less.

Here, the lower limit of the heating temperature is more preferably set to 150°C or higher, and further preferably set to 170°C or higher. On the other hand, the upper limit of the heating temperature is more preferably set to 320°C or lower, and further preferably set to 300°C or lower.

The lower limit of the holding time at the heating temperature is more preferably set to 30 minutes or longer, and further preferably set to 60 minutes or longer. On the other hand, the upper limit of the holding time at the heating temperature is more preferably set to 120 minutes or shorter, and further preferably set to 90 minutes or shorter.

The lower limit of the pressurizing load in the laminating direction is more preferably set to 3 MPa or more, and further preferably set to 5 MPa or more. On the other hand, the upper limit of the pressurizing load in the laminating direction is more preferably set to 15 MPa or less, and further preferably set to 10 MPa or less.

With each step described above, the heat sink integrated insulating circuit substrate 30 according to the present embodiment is manufactured (FIG. 8(d)).

According to the heat sink 10 having the configuration as described above in the present embodiment, the top plate part 11 has a clad structure in which the aluminum layer 12 formed of aluminum or an aluminum alloy and the copper layer 13 formed of copper or a copper alloy are subjected to solid-phase diffusion bonding, and the copper layer 13 is made to serve as the placement surface. Thus, it is possible to spread heat from the semiconductor element 3 along the plate surface of the top plate part 11 by the copper layer 13 with high efficiency, and radiating characteristics are excellent. Further, since the heat sink 10 includes the aluminum layer 12, it is possible to reduce the weight of the heat sink 10.

Further, since the aluminum layer 12 and the copper layer 13 are subjected to solid-phase diffusion bonding and the average crystal grain size D1 of the aluminum layer 12 is set to be 50 $\mu$m or more and less than 500 $\mu$m, the aluminum layer 12 is appropriately hardened, and it is possible to suppress deformation of the aluminum layer.

In addition, since the thickness t of the Al-Cu intermetallic compound layer 15 formed between the aluminum layer 12 and the copper layer 13 is set to be within a range of more than 10 $\mu$m and 40 $\mu$m or less, copper and aluminum are sufficiently subjected to solid-phase diffusion, and the bonding reliability between the copper layer 13 and the aluminum layer 12 is excellent.

Furthermore, in the present embodiment, when the aluminum layer 12 and the radiating fins 18 are integrally molded, it is possible to form the radiating fins 18 having a complicated shape, and it is possible to further improve the radiating characteristics.

Further, since the radiating fin 18 is integrally molded with the aluminum layer 12, it is possible to suppress falling-off or deformation of the radiating fin 18.

In the present embodiment, since the purity of aluminum in the aluminum layer 12 is 99.5 mass% or less, a certain amount of impurities are contained, and it is possible to suppress the growth of crystal grains by the impurities, and to reliably suppress the coarsening of the crystal grains in the aluminum layer 12 after bonding.

The heat sink integrated insulating circuit substrate 30 in the present embodiment includes the heat sink 10 in the present embodiment, the insulating layer 31 formed on the placement surface of the top plate part 11 of the heat sink 10, and the circuit layer 32 formed on the surface of the insulating layer 31 on the opposite side of the top plate part 11. Thus, it is possible to efficiently radiate heat from the semiconductor element 3 mounted on the circuit layer 32, and to suppress deformation of the heat sink 10. In addition, the stable use is possible.

Although the embodiment of the present invention has been described above, the present invention is not limited to the above description, and can be appropriately changed without departing from the technical idea of the invention.

For example, in the present embodiment, the heat sink has been described as having a pin-fin structure, but the heat sink is not limited thereto. The heat sink may include comb-shaped fins and corrugated fins.

Further, in the present embodiment, the heat sink integrated insulating circuit substrate in which the insulating layer is formed at the top plate part of the heat sink has been described as an example. An insulating circuit substrate with a heat sink having a structure in which an insulating circuit substrate in which metal plates are bonded to both surfaces of a ceramic substrate is placed on the top plate part of the heat sink may be formed.

Further, in the present embodiment, a case where the power module is formed by mounting the semiconductor element on the circuit layer has been described, but the present embodiment is not limited to this. For example, an LED module may be formed by mounting an LED element on the circuit layer or a thermoelectric module may be formed by mounting a thermoelectric element on the circuit layer.

[Examples]

Confirmation experiments performed to confirm the effectiveness of the present invention will be described.

First, a copper member and an aluminum member formed of the materials shown in Table 1 were prepared. The copper member was assumed to be a copper plate having a size of 100 mm × 100 mm and a thickness of 1.0 mm.

The aluminum member was assumed to include an aluminum plate having a size of 100 mm × 100 mm and a thickness of 4.0 mm, and a cylindrical pin fin (pin diameter of 1.5 mm and length of 10 mm) integrally molded with the aluminum plate. The number of pin fins was 500.

The purity of aluminum in each aluminum member is 97.9 mass% for A6063, 85.0 mass% for ADC12, 99.5 mass% for A 1050, and 99.99 mass% for 4N-Al.

The purity of aluminum was confirmed by the TCP analysis method.

The copper member and the aluminum member were laminated in a state where the bonding surface between the copper member and the aluminum member was polished in advance to have a smooth surface.

The copper member and aluminum member which had been laminated were introduced into a vacuum furnace, and pressurized and heated under the conditions shown in Table 1 under an atmosphere with a vacuum degree of 0.05 Pa, so that the copper member and the aluminum member are subjected to solid-phase diffusion bonding.

Regarding the heat sink obtained in this manner, the average crystal grain size D1 of the aluminum layer, the thickness of the Al-Cu intermetallic compound layer, the presence or absence of deformation of the radiating fins, and the bonding rate after the thermal cycle is applied were evaluated as follows. Table 2 shows the evaluation results.

(Average Crystal Grain Size of Aluminum Layer)

A cross-section of the aluminum layer along the thickness direction of the top plate part was ion-etched by using a cross-section polisher (SM-09010 manufactured by JEOL Ltd.) at an ion acceleration voltage of 5 kV, a processing time of 14 hours, and a projection amount from a shielding plate of 100 $\mu$m. Then, the result of the ion-etching was observed, and the average crystal grain size of the aluminum layer was measured by using a scanning electron microscope (SEM). The average crystal grain size was measured in accordance with the cutting method described in JIS H 0501.

(Thickness of Al-Cu Intermetallic Compound Layer)

A cross-section of a bonding interface between the aluminum layer and the copper layer was ion-etched by using a cross-section polisher (SM-09010 manufactured by JEOL Ltd.) at an ion acceleration voltage of 5 kV, a processing time of 14 hours, and a projection amount from a shielding plate of 100 $\mu$m. Then, the result of the ion-etching was observed, and the thickness of the Al-Cu intermetallic compound layer formed at the bonding interface was measured.

Regarding the thickness of the Al-Cu intermetallic compound layer, a line analysis was performed on the bonding interface between the aluminum layer and the copper layer in the thickness direction by EPMA (JXA-8530F manufactured by JEOL Ltd., acceleration voltage: 15 kV, spot diameter: 1 $\mu$m or less, magnification: 500, and interval: 0.3 $\mu$m). A region in which each of the Al concentration and the Cu concentration was 1 at% or more was regarded as an Al-Cu intermetallic compound layer, and the thickness was measured.

(Bonding Rate After Thermal cycle is Applied)

A load of a liquid phase (fluorinate) at -40°C for 10 minutes and 150°C for 10 minutes was set as one cycle of the thermal cycle, and 4000 cycles were performed on the heat sink by using the thermal shock tester (TSB-51 manufactured by Espec Co., Ltd.).

Then, the bonding rate (bonding rate between the aluminum layer and the copper layer) of the heat sink after the thermal cycle test was evaluated by using an ultrasonic flaw detector (FineSAT200 manufactured by Hitachi Power Solutions Co., Ltd.) and was calculated from the following expression. Here, the initial bonding area is set to the area to be bonded before bonding. In an image obtained by binarizing the ultrasonic flaw detection image, the exfoliation is indicated by a white part in the bonding part, and thus the area of this white part was taken as the exfoliation area.

$$\text{(Bonding rate)} = \{\text{(initial bonding area)} - \text{(non-bonding part area)}\} / \text{(initial bonding area)} \times 100$$

(Presence or Absence of Deformation of Radiating Fins)

The radiating fins of the heat sink were set in a water jacket, the flow rate was adjusted according to the cross sectional area of the water channel such that the average flow velocity was 1 m/s, and the cooling water (20°C) was circulated.

After the cooling water had circulated for 10 minutes, the radiating fins were taken out from the water jacket, and the presence or absence of deformation of the radiating fins was visually checked.

[Table 1]

| | | | Copper Member | Aluminum Member | | Bonding Step | | |
|---|---|---|---|---|---|---|---|---|
| | | | Material | Material | Average Crystal Grain Size D0 ($\mu$m) | Pressurizing Prerssure (Mpa) | Bonding Temperature (°C) | Holding Time (min) |
| Present Examples | | 1 | OFC | A6063 | 25 | 0.8 | 500 | 90 |
| | | 2 | OFC | ADC12 | 12 | 0.8 | 500 | 60 |
| | | 3 | OFC | A1050 | 52 | 1.2 | 530 | 240 |
| | | 4 | OFC | A6063 | 20 | 0.8 | 500 | 30 |
| | | 5 | OFC | A6063 | 28 | 0.8 | 530 | 300 |
| | | 6 | Tough pitch copper | A6063 | 30 | 1.2 | 500 | 90 |
| Comparative Example | | 1 | OFC | ADC12 | 10 | 0.8 | 480 | 30 |
| | | 2 | OFC | 4N-Al | 120 | 0.8 | 540 | 120 |
| | | 3 | OFC | A6063 | 21 | 0.8 | 500 | 20 |
| | | 4 | OFC | A6063 | 24 | 0.8 | 530 | 350 |

[Table 2]

| | | Average Crystal Grain Size D1 of Aluminum Layer (μm) | Amount of Change of Crystal Grain Size Before And After Bonding (%) | Thickness of Al-Cu Intermetallic Compound Layer (μm) | Evaluation | |
| --- | --- | --- | --- | --- | --- | --- |
| | | | | | Presence or Absence of Deformation of Radiating Fin | Bonding Rate After Thermal Cycle (%) |
| Present Examples | 1 | 120 | 79 | 20 | Absence | 95 |
| | 2 | 53 | 77 | 20 | Absence | 85 |
| | 3 | 495 | 89 | 35 | Absence | 92 |
| | 4 | 75 | 73 | 11 | Absence | 83 |
| | 5 | 180 | 84 | 39 | Absence | 88 |
| | 6 | 110 | 73 | 25 | Absence | 93 |
| Comparative Example | 1 | 42 | 76 | 12 | Absence | 75 |
| | 2 | 515 | 77 | 22 | Presence | 90 |
| | 3 | 70 | 70 | 8 | Absence | 74 |
| | 4 | 200 | 88 | 42 | Absence | 78 |

In Comparative Example 1, the average crystal grain size of the aluminum layer was set to 42 μm, and the bonding rate after the thermal cycle was applied was as low as 75%. It is presumed that this is probably because the aluminum layer became hard and could not sufficiently relieve thermal stress when the thermal cycle was applied.

In Comparative Example 2, the average crystal grain size of the aluminum layer was set to 515 μm, and deformation of the radiating fins was recognized. It is presumed that this is because the crystal growth of the aluminum layer and the radiating fins integrally molded with the aluminum layer was promoted, and the deformation resistance was lowered, during bonding.

In Comparative Example 3, the thickness of the Al-Cu intermetallic compound layer was set to 8 μm, and the bonding rate after the thermal cycle was applied was 74%. It is presumed that this is because the mutual diffusion between Al in the aluminum layer and Cu in the copper layer was insufficient.

In Comparative Example 4, the thickness of the Al-Cu intermetallic compound layer was set to 42 μm, and the bonding rate after the thermal cycle was applied was 78%. It is presumed that this is because the vicinity of the bonding interface became hard and cracks occurred when the thermal cycle was applied.

In contrast, in Examples 1 to 6 in the present invention, the average crystal grain size of the aluminum layer is set to be within a range of 50 μm or more and less than 500 μm, the thickness of the Al-Cu intermetallic compound layer is set to be within a range of more than 10 μm and 40 μm or less, and the bonding rate after the thermal cycle is applied is 83% or more. Thus, excellent bonding reliability is obtained. In addition, no deformation of the radiating fins was observed.

As a result of the above confirmation experiment, according to the present examples, it was confirmed that it is possible to provide a heat sink including the heat sink in which a copper layer formed of copper or a copper alloy and an aluminum layer formed of aluminum or an aluminum alloy are provided, bonding reliability between the copper layer and the aluminum layer is excellent, it is possible to suppress deformation of a member formed of aluminum or an aluminum alloy, and stable use is possible.

[Reference Signs List]

10: Heat sink
11: top plate part
12: Aluminum layer
13: Copper layer
18: Radiating fin
30: Heat sink integrated insulating circuit substrate
31: Insulating layer

32: Circuit layer

**Claims**

1. A heat sink comprising:

   a top plate part; and
   a radiating fin,
   wherein one surface of the top plate part serves as a placement surface on which another member is placed, and the radiating fin is formed on an other surface of the top plate part,
   the top plate part has a clad structure in which an aluminum layer formed of aluminum or an aluminum alloy and a copper layer formed of copper or a copper alloy are subjected to solid-phase diffusion bonding,
   an average crystal grain size of the aluminum layer is set to be within a range of 50 $\mu$m or more and less than 500 $\mu$m, and
   a thickness of an Al-Cu intermetallic compound layer formed between the aluminum layer and the copper layer is set to be within a range of more than 10 $\mu$m and 40 $\mu$m or less.

2. The heat sink according to Claim 1, wherein
   the aluminum layer and the radiating fin are integrally molded.

3. The heat sink according to Claim 1 or 2, wherein
   purity of aluminum in the aluminum layer is 99.5 mass% or less.

4. A heat sink integrated insulating circuit substrate comprising:

   the heat sink according to any one of Claims 1 to 3;
   an insulating layer formed on the placement surface of the top plate part of the heat sink; and
   a circuit layer formed on a surface of the insulating layer on an opposite side of the top plate part.

FIG. 1

EP 4 331 766 A1

FIG. 2

FIG. 3

FIG. 4

# FIG. 5

```
┌─────────────────────────────────┐
│   MEMBER PREPARATION STEP       │ ── S01
└─────────────────────────────────┘
                │
                ▼
┌─────────────────────────────────┐
│        LAMINATING STEP          │ ── S02
└─────────────────────────────────┘
                │
                ▼
┌─────────────────────────────────┐
│         BONDING STEP            │ ── S03
└─────────────────────────────────┘
                │
                ▼
(         HEAT SINK         )
```

# FIG. 6

(a)

23

22A
22B } 22

(b)

23

22A
22B } 22

(c)

13
12 } 11

18          18

10

# FIG. 7

```
┌─────────────────────────────────────────┐
│  RESIN COMPOSITION ARRANGEMENT STEP      │─── S11
└─────────────────────────────────────────┘
                    │
                    ▼
┌─────────────────────────────────────────┐
│      METAL PIECE DISPOSITION STEP        │─── S12
└─────────────────────────────────────────┘
                    │
                    ▼
┌─────────────────────────────────────────┐
│     PRESSURIZING AND HEATING STEP        │─── S13
└─────────────────────────────────────────┘
                    │
                    ▼
(  HEAT SINK INTEGRATED INSULATING CIRCUIT SUBSTRATE  )
```

FIG. 8

<table>
<tr><td colspan="2" align="center">**INTERNATIONAL SEARCH REPORT**</td><td colspan="2">International application No.<br>**PCT/JP2022/018886**</td></tr>
</table>

**A. CLASSIFICATION OF SUBJECT MATTER**

**B23K 20/00**(2006.01)i; **H01L 23/36**(2006.01)i; **H05K 7/20**(2006.01)i
FI: H01L23/36 Z; H05K7/20 D; H05K7/20 C; B23K20/00 310L

According to International Patent Classification (IPC) or to both national classification and IPC

**B. FIELDS SEARCHED**

Minimum documentation searched (classification system followed by classification symbols)

B23K20/00; H01L23/36; H05K7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2020/111107 A1 (MITSUBISHI MATERIALS CORPORATION) 04 June 2020 (2020-06-04)<br>paragraphs [0001]-[0071], fig. 2, 10, table 1 | 1-4 |
| Y | JP 2019-149459 A (MITSUBISHI MATERIALS CORPORATION) 05 September 2019 (2019-09-05)<br>paragraphs [0024], [0027], [0028], table 2 | 1-4 |
| Y | JP 2019-149460 A (MITSUBISHI MATERIALS CORPORATION) 05 September 2019 (2019-09-05)<br>paragraphs [0035], [0036], [0043], table 2 | 1-4 |
| Y | JP 2013-089865 A (SHOWA DENKO KK) 13 May 2013 (2013-05-13)<br>paragraph [0039], table 1 | 1-4 |
| Y | JP 9-298259 A (SUMITOMO METAL IND LTD) 18 November 1997 (1997-11-18)<br>paragraphs [0024], [0025], fig. 1 | 2-4 |
| A | entire text, all drawings | 1 |

☐ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **24 June 2022** | **05 July 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

International application No.

**PCT/JP2022/018886**

| Patent document cited in search report | | | Publication date (day/month/year) | Patent family member(s) | Publication date (day/month/year) |
|---|---|---|---|---|---|
| WO | 2020/111107 | A1 | 04 June 2020 | EP 3888836 A1 paragraphs [0001]-[0116], fig. 2, 10, table 1 | |
| JP | 2019-149459 | A | 05 September 2019 | (Family: none) | |
| JP | 2019-149460 | A | 05 September 2019 | (Family: none) | |
| JP | 2013-089865 | A | 13 May 2013 | (Family: none) | |
| JP | 9-298259 | A | 18 November 1997 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021074746 A
- JP H11204700 A
- JP 2004022914 A
- JP 2014076486 A
- WO 2011155379 A